# EUROPÄISCHE PATENTSCHRIFT

(11) **EP 1 552 733 B1**
(45) Veröffentlichungstag und Bekanntmachung des Hinweises auf die Patenterteilung: **13.12.2006**
(21) Anmeldenummer: 03753285.0
(22) Anmeldetag: 09.09.2003
(51) Int. Cl.: H05K 7/14

(54) **VERFAHREN ZUR MONTAGE EINES SCHALTUNGSMODULS**
METHOD FOR MOUNTING A SWITCHING MODULE
PROCEDE DE MONTAGE D'UN MODULE DE COMMUTATION

(30) Priorität: 14.10.2002 DE 10247773
(43) Veröffentlichungstag der Anmeldung: 13.07.2005
(73) Patentinhaber: SIEMENS AKTIENGESELLSCHAFT, 80333 München (DE)
(72) Erfinder: SMIRRA, Karl, 83512 Wasserburg (DE); SMIT, Arnoud, 93059 Regensburg (DE); SCHEID, Günter, 93152 Nittendorf (DE); FISCHER, Georg, 93186 Reifenthal (DE)
(86) Internationale Anmeldenummer: PCT/DE2003/002991
(87) Internationale Veröffentlichungsnummer: WO 2004/036972

(56) Entgegenhaltungen:
- EP-A- 0 456 022
- GB-A- 2 023 349
- US-A- 4 785 379
- US-A- 5 272 593
- US-A- 6 046 908

## Beschreibung

Die Erfindung betrifft ein Verfahren zur Montage eines Schaltungsmoduls bei dem ein Schaltungsträger in einen Gehäusegrundkörper eingebracht wird und der Gehäusegrundkörper mit Hilfe von Abdeckelementen verschlossen wird.

Die Erfindung betrifft ferner ein Schaltungsmodul mit einer elektronischen Komponente.

In schmutz- und vibrationsbelasteten Umgebungen ist es erforderlich, elektronische Komponenten von der Umgebung abzuschirmen. Für elektronische Getriebesteuerungen werden daher spezielle Gehäuse zur Aufnahme von Leiterplatten entwickelt, die hinsichtlich Größe und Aufbau an die jeweils verwendeten Leiterplatten angepasst sind. Die bekannten Gehäuse weisen untereinander nur eine sehr geringe mechanische Ähnlichkeit auf. Für jede Art von Gehäuse ist zudem ein eigener, neuer Werkzeugsatz zur Herstellung von Bodenplatten, Deckeln, Steckern und weiteren Befestigungsteilen erforderlich.

Gefragt sind jedoch kostengünstig herstellbare und einfach montierbare Gehäuse, die sich zur Aufnahme einer außerhalb des Getriebes angeordneten Steuerungselektronik eignet. Diese Gehäuse können wahlweise dicht oder undicht ausgeführt werden. Der Geräteaufbau und der Montagevorgang soll mit möglichst wenig Bauteilen sowie Arbeits- und Prozessschritten erfolgen. Außerdem soll es möglich sein, die Gehäuse auf einfache Weise an unterschiedliche Abmessungen von Leiterplatten anzupassen, ohne dass ungenutzter Leerraum innerhalb des Gehäuses entsteht.

Aus der Druckschrift US 5,272,593 ist ein Gehäuse für eine elektronische Schaltung, bekannt, in das ein Kühlrahmen mit einer daran befestigten Leiterplatte einschiebbar ist. An dem Kühlrahmen sind dabei Blattfedern befestigt, die sich an Stegen des Gehäuses abstützen und zu einer starken Pressung des Kühlrahmens auf die Gehäusewand führen.

Ausgehend von diesem Stand der Technik liegt der Erfindung deshalb die Aufgabe zugrunde, ein einfaches und kostengünstiges Verfahren zur Montage eines Schaltungsmoduls zu schaffen.

Diese Aufgaben werden durch das Verfahren und das Schaltungsmodul mit den in den unabhängigen Ansprüchen angegebenen Merkmalen gelöst. In davon abhängigen Ansprüchen sind vorteilhafte Ausgestaltungen und Weiterbildungen angegeben.

Zur Herstellung eines Gehäuses wird der Gehäusegrundkörper bevorzugt durch Abteilen eines Hohlprofils hergestellt und die Öffnungen auf den Querseiten des Gehäusegrundkörpers mit den Abdeckelementen geschlossen.

Da der Gehäusegrundkörper durch Abteilen eines Hohlprofils hergestellt wird, kann die Länge des Gehäusegrundkörpers nahezu beliebig variiert werden. Es ist daher möglich, ausgehend von einem Hohlprofil, verschieden lange Gehäusegrundkörper herzustellen, die mit verschieden langen Schaltungsträgern bestückt werden können. Die Länge des Gehäusegrundkörpers kann insbesondere so gewählt werden, dass innerhalb des Gehäuses keine Leervolumina entstehen.

Das Hohlprofil wird vorzugsweise stranggepresst. Dabei lässt sich das Querschnittsprofil auf einfache Weise derart gestalten, dass ein Schaltungsträger ohne weitere Befestigungsmittel im Gehäuse befestigt werden kann. So ist es zum Beispiel möglich, sich entlang der Längsachse des Hohlprofils erstreckende Ausnehmungen vorzusehen, in die selbstschneidende Schrauben zur Befestigung der Abdeckelemente einschraubbar sind. Weiterhin können im Querschnittsprofil Auflageflächen für den Schaltungsträger vorgesehen sein, die so angeordnet werden, dass auch ein beidseitig bestückter Schaltungsträger in den Gehäusegrundkörper eingeschoben werden kann.

Der Schaltungsträger wird so in den Gehäusegrundkörper eingebracht, dass der Schaltungsträger mit seinen Flachseiten zu Wänden des Gehäusegrundkörpers weist. In den Zwischenraum zwischen Gehäusegrundkörper und dem Schaltungsträger wird eine langgestreckte Druckleiste eingebracht, die jeweils am Gehäusegrundkörper und am Schaltungsträger anliegt. Durch die von der Druckleiste erzeugte Presskraft wird der Schaltungsträger gegen den Gehäusegrundkörper gedrückt und auf diese Weise im Gehäusegrundkörper gehalten.

Diese Lösung bietet den Vorteil, dass sich die Druckleiste auf einfache Weise durch diejenige Öffnung einbringen lässt, durch die auch der Schaltungsträger in den Gehäusegrundkörper eingebracht worden ist. Es sind daher keine zusätzlichen Öffnungen im Gehäusegrundkörper erforderlich, um den Schaltungsträger im Gehäusegrundkörper zu befestigen. Da zum Niederhalten des Schaltungsträgers eine Druckleiste verwendet wird, besteht nicht die Gefahr, dass sich die Halterung unter Vibrationsbelastung löst. Die Halterung mit Hilfe der zwischen Gehäusegrundköper und Schaltungsträger eingebrachten Druckleiste ist daher einfach zu montieren und gewährleistet eine sichere Fixierung des Schaltungsträgers.

Bei einer bevorzugten Ausführungsform ist die Druckleiste schlangenförmig ausgebildet. Wenn sich die Schlangenfeder zusammenzieht, findet eine Kraftübersetzung statt, durch die die auf den Schaltungsträger wirkende Haltekraft verstärkt werden kann.

Bei einer besonders bevorzugten Ausführungsform ist die Druckleiste eine schlangenförmige Zugfeder, die sich im Zwischenraum zwischen dem Schaltungsträger und einer Wand des Gehäusegrundkörpers zusammenzieht. Eine derartige Druckleiste ist besonders gut vor Verklemmen geschützt, da Klemmstellen durch die Zugkraft der Feder gelockert werden.

Bei einer weiteren bevorzugten Ausführungsform weist die Druckleiste hintereinander angeordnete Federringe auf, die bei der Montage des Schaltungsträgers so verformt werden, dass sie eine Federkraft zwischen den Wänden des Gehäusegrundkörpers und des Schaltungsträgers vermitteln.

Zur Sicherung der Leiterplatte im Gehäusegrundkörper ist bei einer weiteren Ausführungsform ein Abdeckelement mit einem Schwert versehen, das sich in das Innere des Gehäusegrundkörpers erstreckt, wenn dieses Abdeckelement an der Querseite des Gehäusegrundkörpers angebracht ist. Für die Führung des Schwerts im Inneren des Gehäusegrundkörpers können Führungsnuten vorgesehen sein, die bevorzugt gekapselt ausgeführt werden, um ein Abscheren von elektronischen Bauelementen auf der Leiterplatte beim Einführen des Schwerts zu verhindern. Um schließlich die Leiterplatte in dem Gehäusegrundkörper zu halten, sind entlang den Schwertern Federelemente ausgebildet, die die Leiterplatte auf eine Auflagefläche drücken. In einer bevorzugten Ausführungsform sind diese Federelemente aus einem gut wärmeleitenden Material, insbesondere einem Metall, z.B. einer Kupfer-Beryllium-Legierung, hergestellt, so dass über die Federelemente Wärme von der Leiterplatte auf den Grundkörper abgeleitet werden kann.

Bei einer abgewandelten Ausführungsform werden die Abdeckelemente, die gegenüberliegende Öffnungen verschließen, komplementär ausgebildet, indem eines der Abdeckelemente mit einem Schwert versehen wird, das formschlüssig in eine Ausnehmung des gegenüberliegenden Abdeckelements eingreift. Dies kann mit Hilfe einer Verrasterung, Verhakung oder Verzahnung geschehen.

Bei einer weiteren bevorzugten Ausführungsform ist ein Abdeckelement mit einem Kontaktmittel, zum Beispiel einer Buchse oder einem Stecker, versehen. Das Kontaktmittel wird bevorzugt vor dem Einschieben der Leiterplatte in den Gehäusegrundkörper an der Leiterplatte befestigt. Die Leiterplatte führt dann beim Einschieben in den Gehäusegrundkörper das Abdeckelement, so dass dieses beispielsweise während eines Einschraubvorgangs auf Position gehalten wird. Nach dem Befestigen des Abdeckelements am Gehäusegrundkörper wird die über das Kontaktmittel am Abdeckelement befestigte Leiterplatte im Gehäusegrundkörper sicher gehalten.

Zur Ableitung der von der elektronischen Komponente erzeugten Wärme können außen am Gehäusegrundkörper sich entlang der Längsachse erstreckende Kühlrippen ausgebildet sein. Ferner ist es gegebenenfalls sinnvoll, an den Abdeckelementen Kühlrippen vorzusehen, durch die die Abwärme an die Umgebungsluft abgegeben werden kann.

Nachfolgend wird die Erfindung beispielhaft anhand der beigefügten Zeichnung erläutert. Es zeigen:
- Figur 1: eine perspektivische Ansicht eines mit einem Stecker versehenen Abdeckelements, das an einer Leiterplatte befestigbar ist;
- Figur 2: eine perspektivische Ansicht eines aus einem stranggepressten Hohlprofil hergestellten Hohlkörpers;
- Figur 3: eine perspektivische Ansicht eines Befestigungsvorgangs, bei dem die Leiterplatte und das daran angebrachte Abdeckelement in den Hohlkörper aus Figur 2 eingeschoben werden;
- Figur 4: eine perspektivische Ansicht des Befestigungsvorgangs des gegenüberliegenden Abdeckelements an dem Hohlkörper aus den Figuren 2 und 3;
- Figur 5: eine perspektivische Vorderansicht eines fertig montierten Schaltungsmoduls;
- Figur 6: eine perspektivische Ansicht auf die Rückseite des Schaltungsmoduls aus Figur 5;
- Figur 7: einen Querschnitt durch das Schaltungsmodul aus den Figuren 5 und 6;
- Figur 8: einen Querschnitt durch eine abgewandelte Ausführungsform eines Schaltungsmoduls;
- Figur 9: eine perspektivische Ansicht eines Befestigungsvorgangs, bei dem eine Leiterplatte in einen abgewandelten Hohlkörper eingeführt und ein Abdeckelement an dem Hohlkörper befestigt wird;
- Figur 10: eine perspektivische Ansicht eines rückseitigen Abdeckelements für den Hohlkörper aus Figur 9;
- Figur 11: eine perspektivische Ansicht, die ein Anbringen des rückseitigen Abdeckelements aus Figur 10 am Hohlkörper veranschaulicht;
- Figur 12: eine Detailzeichnung, die das Anbringen des rückseitigen Abdeckelements zeigt;
- Figur 13: eine Detailzeichnung, die das an der Leiterplatte angebrachte rückseitige Abdeckelement zeigt;
- Figur 14: eine Explosionsansicht eines abgewandelten Schaltungsmoduls;
- Figur 15A bis 15C: Querschnitte durch das Schaltungsmodul aus Figur 14 beim Einschieben der Leiterplatte;
- Figur 16: einen Querschnitt durch das Schaltungsmodul aus Figur 14, in dem die auf eine Federleiste wirkenden Kräfte eingezeichnet sind;
- Figur 17: einen Querschnitt durch das Schaltungsmodul aus Figur 14 mit einer verklemmten Federleiste;
- Figur 18: einen weiterer Querschnitt durch das Schaltungsmodul aus den Figuren 14 bis 17;
- Figur 19: einen Querschnitt durch ein abgewandeltes Schaltungsmodul, bei dem eine Federleiste mit einzelnen Federzungen verwendet wird;
- Figur 20: einen Querschnitt durch ein Schaltungsmodul, bei dem eine Federleiste mit Federringen verwendet wird; und
- Figur 21A und 21B: eine Darstellung der Kompression einer mit Federringen ausgestatteten Federleiste.

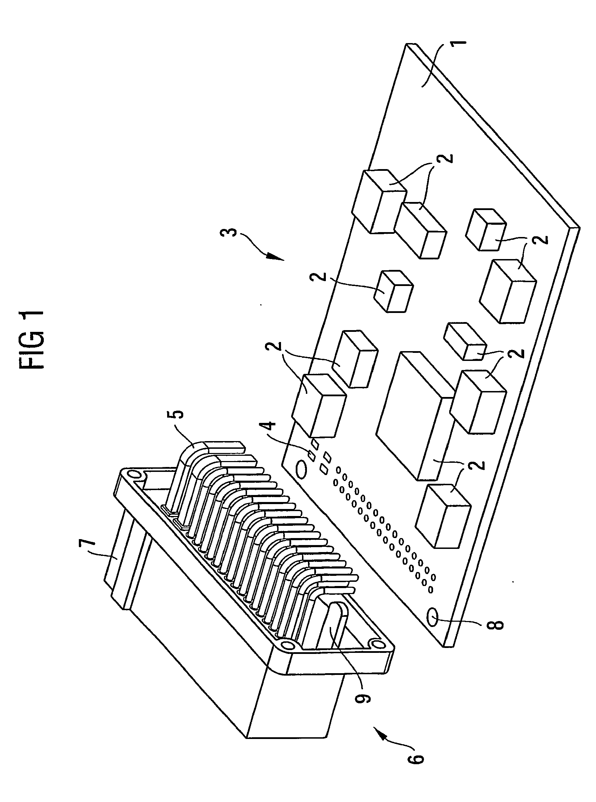

Figur 1 zeigt eine Leiterplatte 1, die mit elektronischen Bauelementen 2 bestückt ist. Die Leiterplatte 1 wird zusammen mit den Bauelementen 2 nachfolgend als elektronische Komponente 3 bezeichnet. In der Leiterplatte 1 sind Lötaugen 4 für Kontaktstifte 5 eines an einem Abdeckelement 6 ausgebildeten Steckers 7 vorgesehen. Das mit dem Stecker 7 versehene Abdeckelement 6 wird im Folgenden auch als vorderseitiges Abdeckelement 6 bezeichnet.

Die Leiterplatte 1 verfügt darüber hinaus über Rastlöcher 8, in die am Abdeckelement 6 ausgebildete Rastnoppen 9 einrasten können.

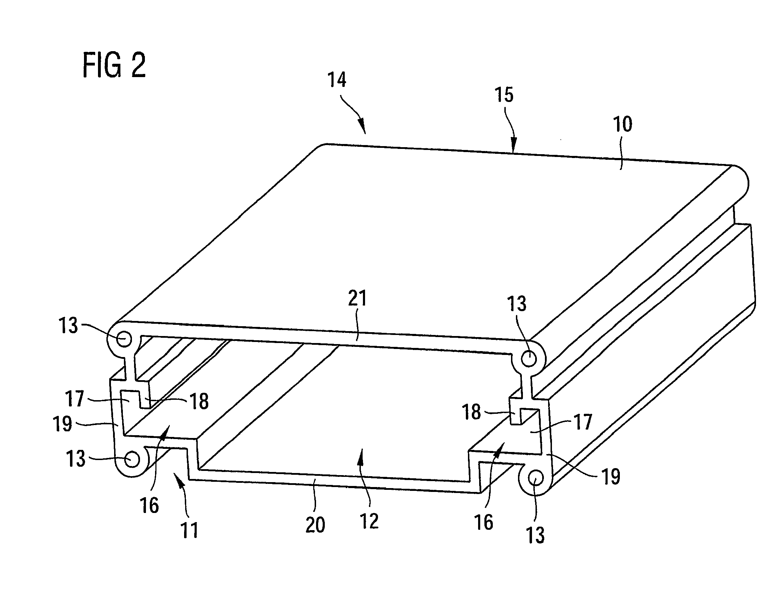

In Figur 2 ist ein Hohlkörper 10 dargestellt, der entsprechend der Länge der Leiterplatte 1 von einem Hohlraumprofil abgeteilt wurde. Das Hohlprofil ist somit das Halbzeug, aus dem der Hohlkörper 10 durch einen einfachen Trennvorgang hergestellt wird. Das Querschnittsprofil des Hohlkörpers 10 ist so gestaltet, dass das Abdeckelement 6 an einer vorderen Querseite 11 angebracht werden kann, um eine vordere Öffnung 12 abzuschließen. Zu diesem Zweck sind entlang den Längskanten des Hohlkörpers 10 Ausnehmungen 13 vorgesehen, in die beispielsweise selbstschneidende Schrauben einschraubbar sind. Die Ausnehmungen 13 erstrecken sich entlang den Längskanten des Hohlkörpers 10 und der vorderen Querseite 11 bis zu einer hinteren Querseite 14, so dass auch auf der hinteren Querseite 14 eine hintere Öffnung 15 mit Hilfe eines geeigneten Abdeckelements abdeckbar ist.

Das Querschnittsprofil ist ferner so gestaltet, dass Auflageflächen 16 vorhanden sind, auf denen die eingeschobene Leiterplatte 1 aufliegt. Bei dem in Figur 2 dargestellten Ausführungsbeispiel des Hohlkörpers 10 sind die Auflageflächen 16 so angeordnet, dass auch eine beidseitig bestückte Leiterplatte 1 in den Hohlkörper 10 einschiebbar ist. Die Höhe des Hohlkörpers 10 ist so gewählt, dass die üblicherweise auf der Leiterplatte 1 verwendeten Bauelemente 2 ausreichend Platz im Hohlkörper 10 finden.

Durch die Auflageflächen 16 wird ein großflächiger Kontakt zwischen dem Hohlkörper 10 und der in den Hohlkörper 10 eingeschobenen Leiterplatte 1 hergestellt. Über diese großflächigen Kontaktstellen kann die von den Bauelementen 2 auf der Leiterplatte 1 erzeugte Verlustwärme von der Leiterplatte 1 auf den Hohlkörper 10 übertragen und von dort an die Umgebungsluft abgegeben werden.

Ferner sind im Hohlkörper 10 gekapselte Führungsnuten 17 vorgesehen, deren Funktion im Folgenden näher erläutert werden wird. Bei dem in Figur 2 dargestellten Ausführungsbeispiel sind die Führungsnuten 17 jeweils von einem inneren Führungssteg 18 und einer seitlichen Außenwand 19 gebildet. Die Auflageflächen 16 dagegen sind Teil der unteren Außenwand 20 des Hohlkörpers 10. Die obere Außenwand 21 weist keinen besonderen Verlauf auf und verläuft in gerader Linie zwischen den entlang den Längskanten angeordneten Ausnehmungen 13.

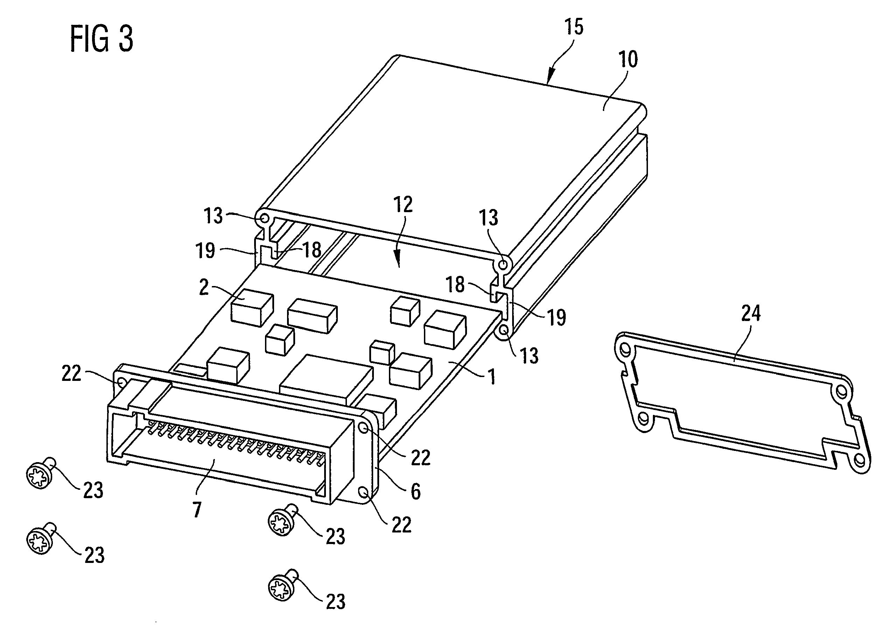

Figur 3 zeigt in einer perspektivischen Ansicht, wie die Leiterplatte 1 in den Hohlkörper 10 eingeschoben wird. Zunächst wird die Leiterplatte 1 auf die Auflageflächen 16 aufgelegt und dann unter dem Führungssteg 18 hindurch in den Hohlkörper 10 eingeschoben. Beim Einschieben der Leiterplatte 1 wird diese von der Auflagefläche 16 und den seitlichen Außenwänden 19 geführt. Durch diese Art der Führung wird auch dafür gesorgt, dass Schraubenlöcher 22 des Abdeckelements 6 auf den Ausnehmungen 13 des Hohlkörpers 10 zu liegen kommen. Das Abdeckelement 6 kann dann mit Hilfe von selbstschneidenden Schrauben 23 am Hohlkörper 10 befestigt werden. Wahlweise kann auch ein Dichtring 24 zwischen den Hohlkörper 10 und das Abdeckelement 6 eingebracht werden. Der Dichtring 24 folgt in seinem Querschnittsprofil dem Querschnittsprofil des Hohlkörpers 10, so dass das Abdeckelement 6 nach dem Einschieben der Leiterplatte 1 in den Hohlkörper 10 den Hohlkörper 10 dicht abschließt.

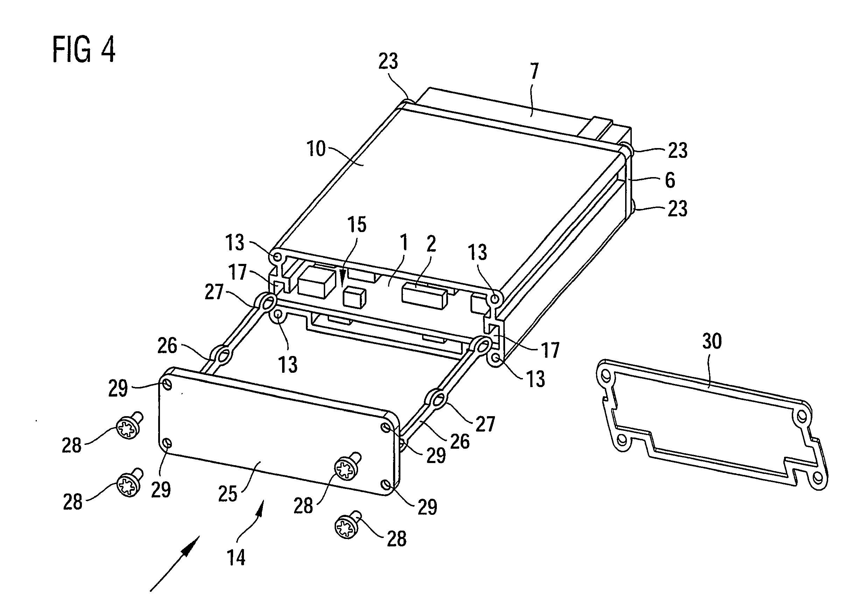

Figur 4 zeigt in einer perspektivischen Ansicht die Montage eines rückseitigen Abdeckelements 25. Das rückseitige Abdeckelement 25 ist mit Schwertern 26 ausgestattet, an denen Federringe 27 ausgebildet sind. Der Außendurchmesser der Federringe 27 ist etwas größer als die Höhe der Führungsnuten 17 abzüglich der Dicke der Leiterplatte 1. Die Schwerter 26 müssen daher mit Kraft in die Führungsnuten 17 eingeschoben werden. Während des Einschiebevorgangs nehmen die Schrauben 23 die auf die Leiterplatte 1 wirkenden Schubkräfte auf.

Bei einem abgewandelten Ausführungsbeispiel sind die Federringe 27 durch weitere Federelemente ersetzt. So können die Schwerter 26 wellenförmig ausgebildet sein oder Blattfedern aufweisen, die in Querrichtung wirken. Die Schwerter 26 können sowohl aus Metall als auch Kunststoff gefertigt sein.

In einer bevorzugten Ausführungsform sind die Federringe oder Federelemente aus einem gut wärmeleitenden Material, insbesondere einem Metall, z.B. einer Kupfer-Beryllium-Legierung, hergestellt. Dadurch kann über die Federringe oder Federelemente Wärme auch von der der Auflagefläche 16 abgewandten Seite der Leiterplatte 1 auf den Hohlkörper 10 gut abgeleitet werden.

Damit die Schwerter 26 beim Einschieben nicht ausweichen und die auf der Leiterplatte 1 angeordneten Bauelemente 2 abscheren, sind die inneren Führungsstege 18 vorgesehen. Durch die Federringe 27 wird die Leiterplatte 1 fest gegen die Auflageflächen 16 gedrückt. Auf diese Weise ist der Wärmeübergang zwischen der Leiterplatte 1 und dem Hohlkörper 10 sichergestellt. Ferner ist die Leiterplatte 1 gegen Vibrationsbelastungen gesichert.

Es sei angemerkt, dass zwischen der Leiterplatte 1 und der Auflagefläche 16 eine Wärmeleitpaste oder Wärmeleitfolie vorhanden sein kann, durch die die Leiterplatte 1 vom Hohlkörper 10 isoliert wird. Die Isolation der Leiterplatte 1 vom Hohlkörper 10 kann auch durch Eloxieren des Hohlkörpers 10 bewerkstelligt werden. In diesen Fällen kann die Leiterplatte zunächst in Kontakt mit den Führungsstegen 18 in den Hohlkörper 10 eingeführt werden und dann in der letzten Phase des Einschiebens auf die Auflageflächen 16 aufgelegt und mit den Schwertern 26 des rückseitigen Abdeckelements 25 festgepresst werden, damit die von den Wärmeleitpaste, der Wärmeleitfolie oder der Oxidschicht bewerkstelligte elektrische Isolation erhalten bleibt.

Nach dem Einschieben des rückseitigen Abdeckelements 25 wird das rückseitige Abdeckelement 25 mit Hilfe von selbstschneidenden Schrauben 28 am Hohlkörper 10 befestigt. Die Führung der Schwerter 26 in den Führungsnuten 17 sorgt dabei für einen passenden Sitz von Schraubenlöchern 29 des rückseitigen Abdeckelements 25 auf den Ausnehmungen 13 des Hohlkörpers 10.

Das rückseitige Abdeckelement 25 und die Schwerter 26 werden vorzugsweise einstückig als Spritzgussteile hergestellt. Bei einem abgewandelten Ausführungsbeispiel sind die Abdeckelemente 25 und die Schwerter 26 separate Teile, die getrennt montiert werden. Anstelle der Schwerter 26 können zum Beispiel als Schüttgut angelieferte Federleisten, an denen die Federringe 27 ausgebildet sind, in den Hohlkörper 10 eingesetzt werden.

Zwischen dem rückseitigen Abdeckelement 25 und dem Hohlkörper 10 kann weiterhin ein Dichtring 30 eingebracht sein. Der Dichtring 30 bewirkt einen dichten Verschluss der rückseitigen Öffnung 15 durch das rückseitige Abdeckelement 25.

Der Dichtring 30 weist die gleiche Form wie der Dichtring 24 auf. Es ist also möglich, mit einer Art von Dichtring die beiden Öffnungen 12 und 15 abzudichten.

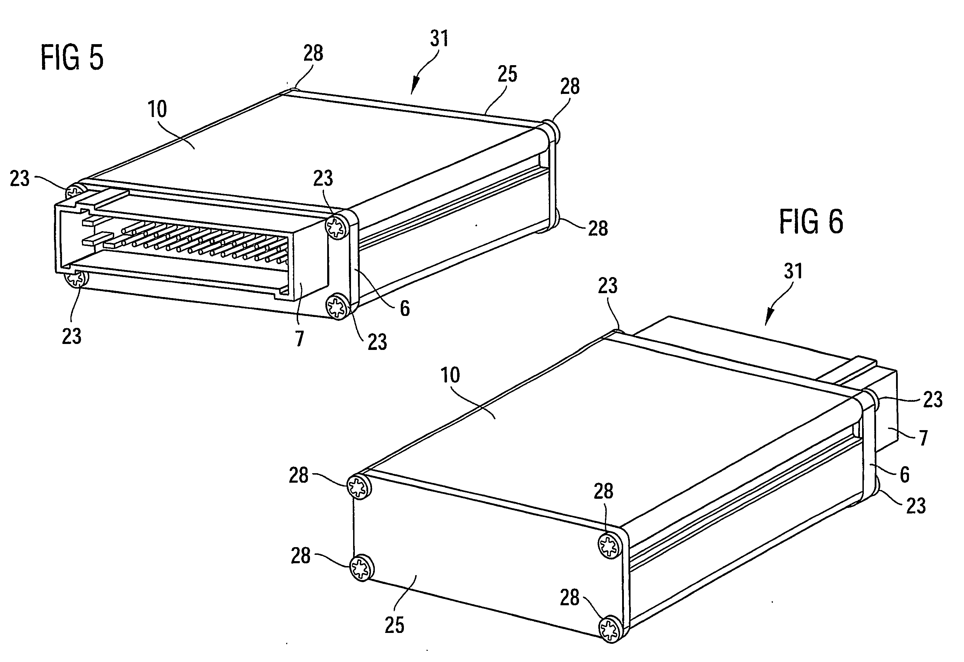

In Figur 5 ist eine perspektivische Ansicht eines fertig montierten Schaltungsmoduls 31 dargestellt. Figur 6 zeigt daneben eine perspektivische Ansicht von hinten auf das fertig montierte Schaltungsmodul 31.

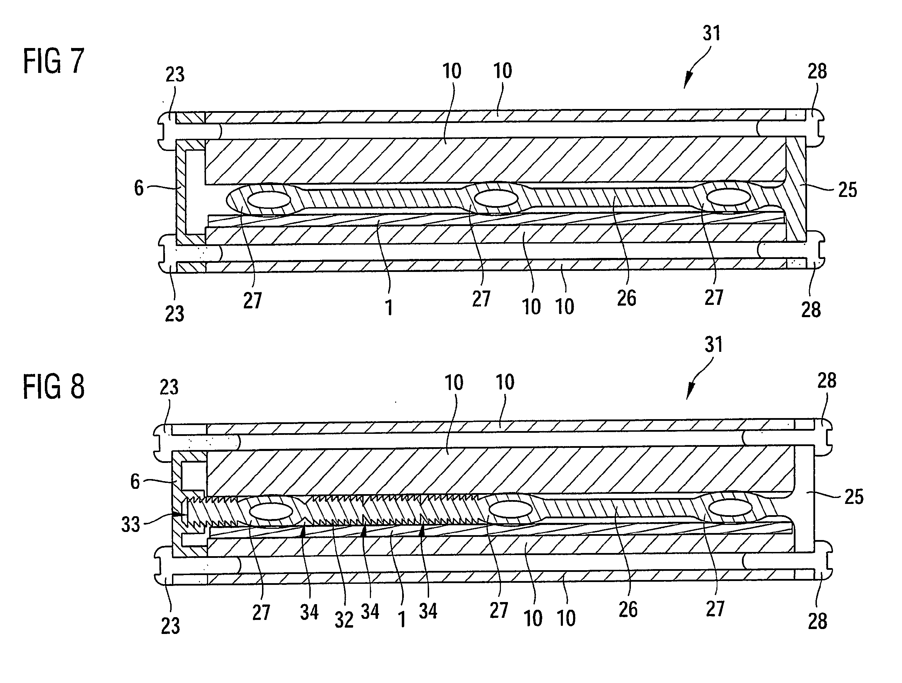

Figur 7 zeigt einen Querschnitt durch das Schaltungsmodul 31. Deutlich erkennbar ist, dass die Federringe 27 in der Führungsnut 17 komprimiert sind und so eine Federkraft auf die Leiterplatte 1 ausüben, durch die die Leiterplatte 1 auf die Auflagefläche 16 gedrückt wird.

In Figur 8 ist ein Querschnitt durch ein abgewandeltes Ausführungsbeispiel des Schaltungsmoduls 31 dargestellt. Bei diesem Ausführungsbeispiel sind die Schwerter 26 mit einem Sägezahnprofil 32 versehen, das im Bereich des vorderseitigen Abdeckelements 6 formschlüssig in Verzahnungen einer Ausnehmung 33 eingreift. Dadurch werden das rückseitige Abdeckelement 25 und das vorderseitige Abdeckelement 6 gegeneinander verrastet. Insbesondere wird der Hohlkörper 10 zwischen dem vorderseitigen Abdeckelement 6 und dem rückseitigen Abdeckelement 25 eingeklemmt. Bei dem in Figur 8 dargestellten abgewandelten Ausführungsbeispiel des Schaltungsmoduls 31 kann daher im Grunde auf die Schrauben 23 und 28 verzichtet werden. Auf diese Weise kann mit sehr wenigen Fügeschritten und ohne Schraub- und Klebevorgänge ein steifes und dichtes Schaltungsmodul 31 bewerkstelligt werden.

Das Sägezahnprofil 32, die Länge der Schwerter 26 und die Verrasterung der Ausnehmungen 33 sollen so bemessen werden, dass die Schwerter 26 mit einer ausreichenden Einstecklänge in die Ausnehmungen 33 hineinreichen. Damit die Länge der Schwerter 26 an die Länge der Leiterplatten 1 angepasst werden kann, sind Sollbruchstellen 34 entlang den Schwertern 26 vorgesehen, durch die die Länge der Schwerter 26 verkürzt und somit an die Länge des jeweiligen Hohlkörpers 10 und der jeweiligen Leiterplatte 1 angepasst werden kann. Durch Ablängen an den Sollbruchstellen 34 können daher die Schwerter 26 an die jeweils vorliegende Länge der Leiterplatte 1 angepasst werden. In einem weiteren, nicht dargestellten Ausführungsbeispiel des Schaltungsmoduls 31 ist der Hohlkörper 10 auf der Außenseite mit Kühlrippen versehen, womit sich der Wärmeübergang vom Hohlkörper 10 auf die Umgebungsluft verbessern lässt.

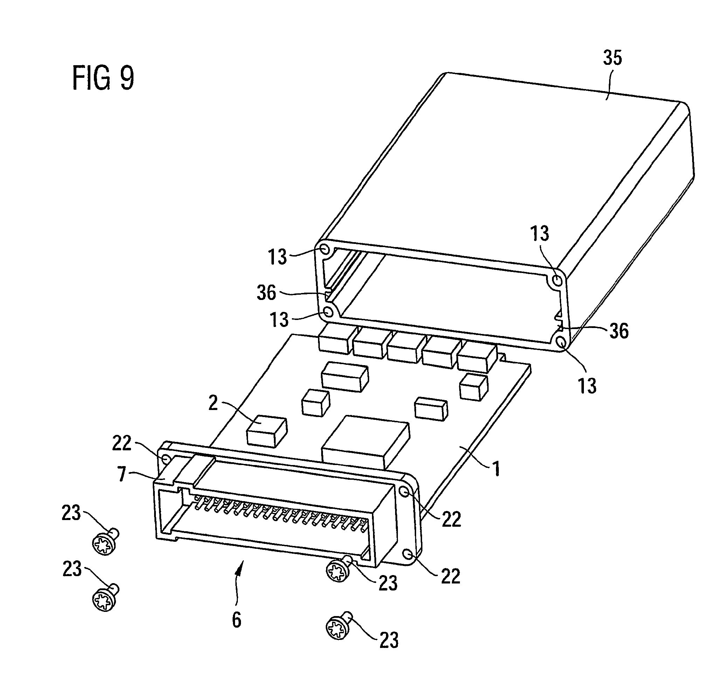

Der Hohlkörper 10 des in den Figuren 5 und 6 dargestellten Schaltungsmoduls 31 ist vorzugsweise aus einem metallischen Material gefertigt. Die in Figur 9 dargestellte Ausführungsform verfügt dagegen über einen Hohlkörper 35, der aus Kunststoff hergestellt ist. Im Inneren des Hohlkörpers 35 sind Führungsnuten 36 vorgesehen, die die Leiterplatte 1 beim Einschieben umschließen. Da die von der Leiterplatte 1 erzeugte Wärme nicht über den Hohlkörper 35 aus Kunststoff abgeführt werden soll, ist keine spezielle Auflagefläche vorgesehen, durch die ein großflächiger Kontakt zwischen der Leiterplatte 1 und dem Hohlkörper 35 hergestellt wird. Vielmehr beschränkt sich die Funktion der Führungsnuten 36 darauf, die Leiterplatte 1 sicher im Inneren des Hohlkörpers 35 zu fixieren.

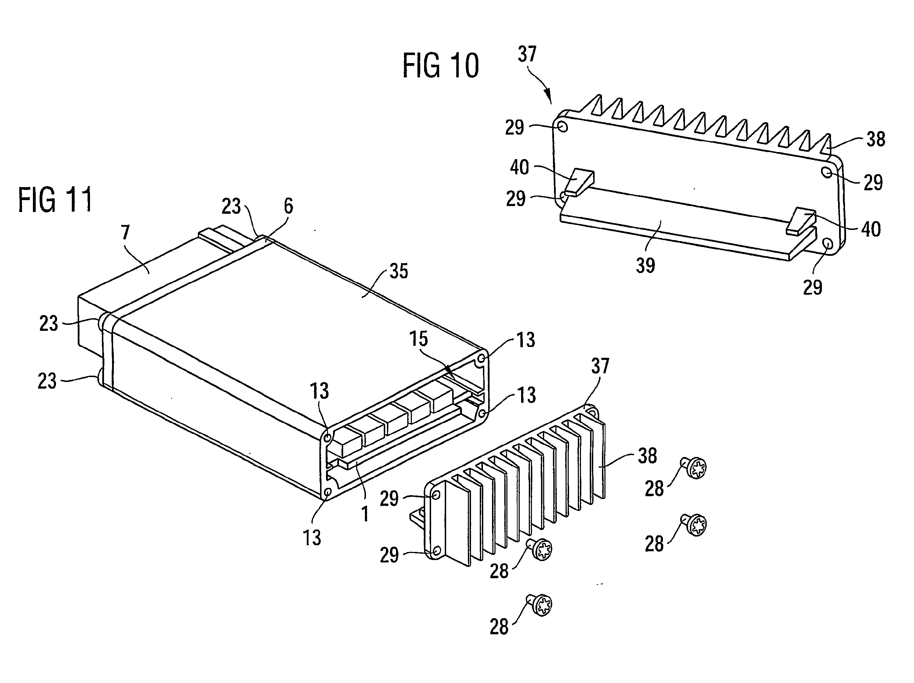

Die Kühlung muss daher auf andere Art und Weise bewerkstelligt werden. Figur 10 zeigt ein metallisches rückseitiges Abdeckelement 37, das auf seiner Außenseite mit Kühlrippen 38 versehen ist. Auf seiner Innenseite weist das rückseitige Abdeckelement 37 eine Kontaktleiste 39 sowie zwei seitlich angeordnete Klemmnasen 40 auf. Das rückseitige Abdeckelement 37 wird, wie in Figur 11 dargestellt, auf die hintere Öffnung 15 des Hohlkörpers 35 aufgebracht und dort mit Hilfe der Schrauben 28 verschraubt.

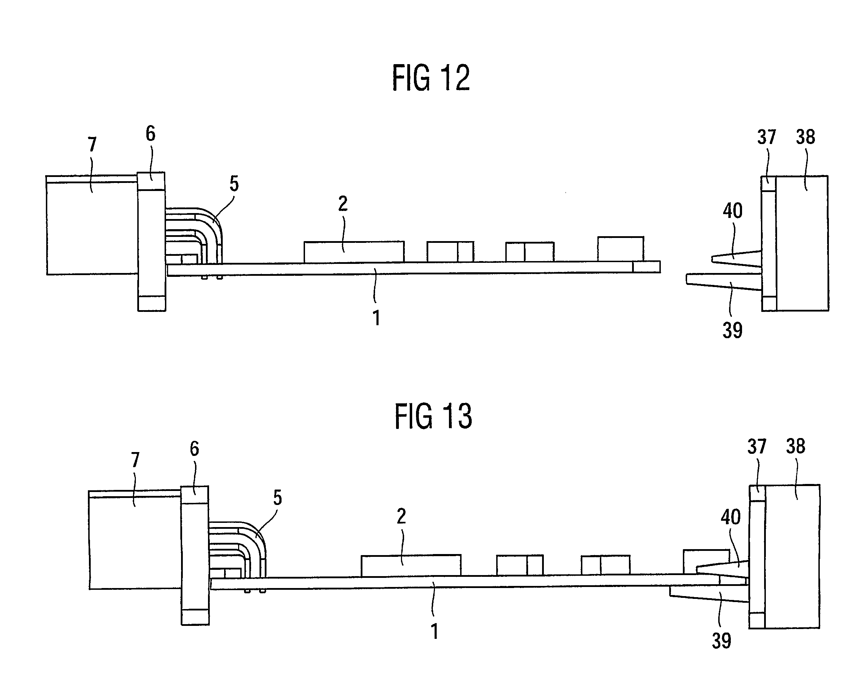

Figur 12 zeigt eine Querschnittsansicht der Leiterplatte 1 und des rückseitigen Abdeckelements 37 zu einem Zeitpunkt, zu dem das rückseitige Abdeckelement 37 noch nicht vollständig auf die Leiterplatte 1 aufgeschoben ist. In Figur 13 dagegen ist das rückseitige Abdeckelement 37 bereits vollständig auf die Leiterplatte 1 aufgeschoben. Die Kontaktleiste 39 liegt großflächig auf der Unterseite der Leiterplatte 1 an und bewerkstelligt den Wärmeübergang zwischen der Leiterplatte 1 und dem rückseitigen Abdeckelement 37. Die keilförmig ausgebildeten Klemmnasen 40 sorgen dabei für den nötigen Anpressdruck.

Das hier beschriebene Gehäusekonzept bietet eine Reihe von Vorteilen. Zum einen können die Hohlkörper 10 und 35 an die verschiedenen Arten von Leiterplatten 1 angepasst werden. Die Anpassung kann ohne Werkzeugänderung vorgenommen werden, da lediglich der Schneidevorgang modifiziert werden muss. Insgesamt braucht nur ein Satz von Werkzeugen für die Extrusion des Hohlkörpers 10 oder des Hohlkörpers 35 hergestellt werden. Die Länge der Hohlkörper 10 und 35 kann immer so gewählt werden, dass im Inneren des fertigen Schaltungsmoduls keine Leerräume entstehen. Ein weiterer Vorteil ist der geringe Montageaufwand, der durch die geringe Anzahl von Teilen bedingt ist. Erleichtert wird die Montage auch dadurch, dass im Wesentlichen nur Fügeprozesse durchgeführt werden müssen. Trotz der einfachen Montage können steife, mechanisch feste und hermetisch dichte Gehäuse hergestellt werden. Ein weiterer Vorteil ist, dass mit Hilfe der Gehäuse die auf der Leiterplatte 1 erzeugte Abwärme sicher abgeführt werden kann. Außerdem ergibt sich eine hohe Vibrationsfestigkeit, da die Leiterplatte 1 in den Hohlkörpern 10 und 35 von wenigstens drei Seiten großflächig gefasst wird.

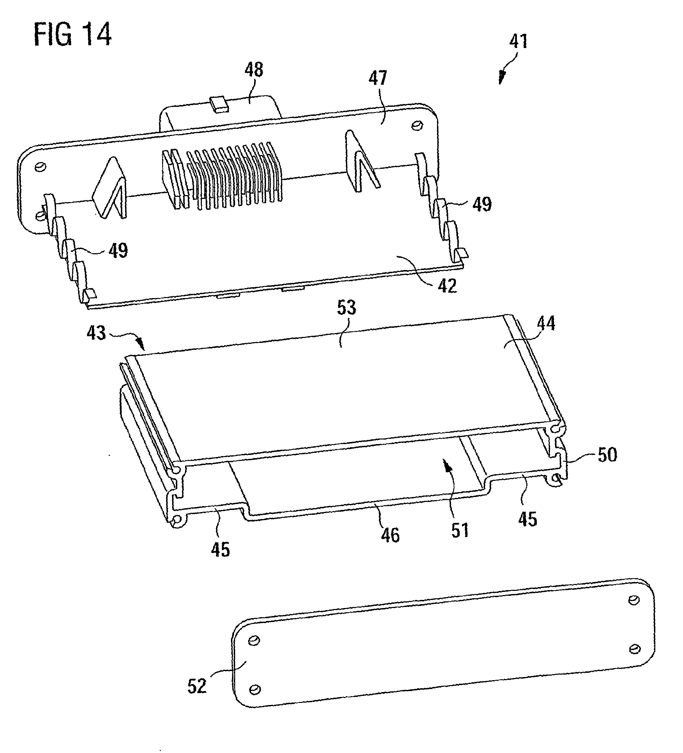

In Figur 14 ist eine Explosionsansicht eines weiteren Schaltungsmoduls 41 dargestellt, das beispielsweise auf einer Leiterplatte 42 die Schaltung einer Getriebesteuerung oder einer Motorsteuerung beherbergt. Die Leiterplatte 42 kann durch eine vorderseitige Öffnung 43 eines Gehäusegrundkörpers 44 in den Gehäusegrundkörper 44 eingebracht werden. Die Leiterplatte 42 liegt während des Einschiebens auf Schultern 45 eines Gehäusebodens auf. Bei dem Gehäusegrundkörper 44 kann es sich beispielsweise um den abgetrennten Teil eines Strangpressprofils handeln, das aus Aluminium oder Kunststoff hergestellt ist.

Die Leiterplatte 42 ist bereits vor dem Einbringen in den Gehäusegrundkörper 44 an einer vorderseitigen Abdeckung 47 angebracht worden, die nach außen hin über eine Buchse 48 verfügt, mit der die Leiterplatte 42 elektrisch kontaktiert werden kann. An der Abdeckung 47 sind auch Federleisten 49 befestigt, die beim Einschieben der Leiterplatte 42 in den Gehäusegrundkörper 44 in gekapselte Führungsnuten 50 des Gehäusegrundkörpers 44 eingebracht werden. Das Einbringen der Federleisten 49 wird nachfolgend noch im Einzelnen beschrieben.

Nach dem Einbringen der Leiterplatte 42 und der Federleisten 49 in den Gehäusegrundkörper 44 wird eine rückseitige Öffnung 51 des Gehäusegrundkörpers 44 durch eine rückseitige Abdeckung 52 verschlossen.

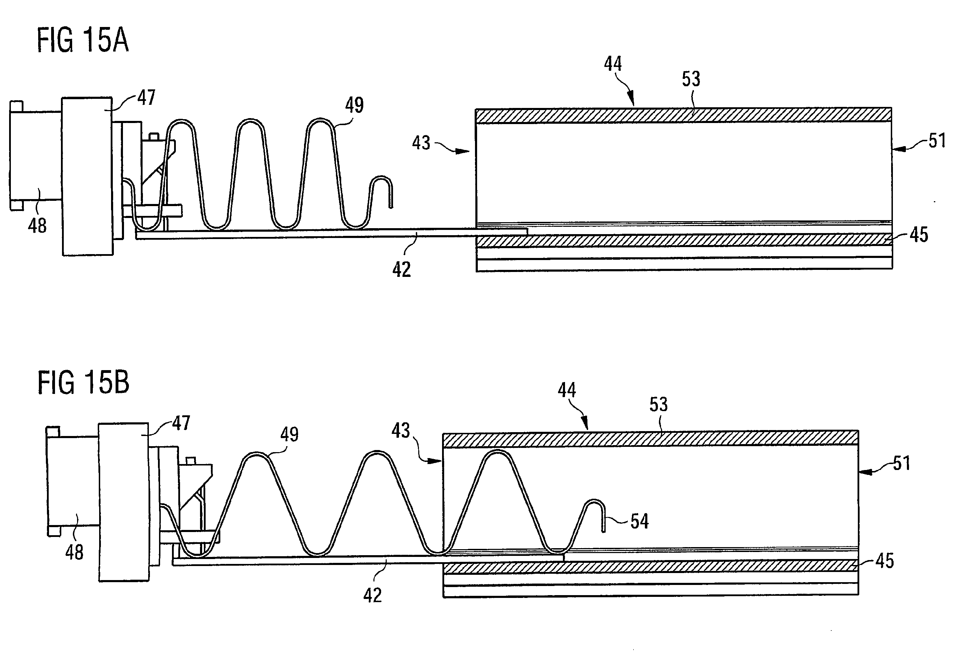

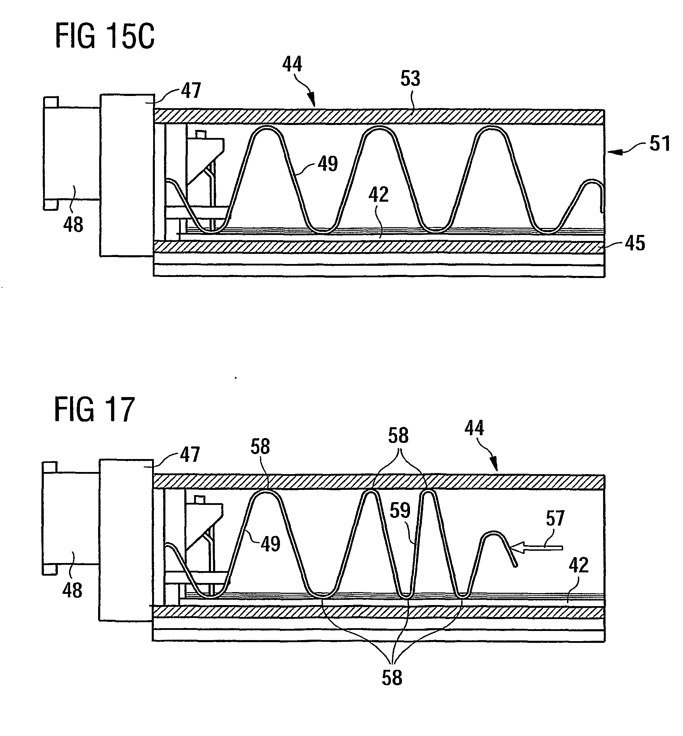

In den Figuren 15A bis 15C ist das Einbringen der Federleiste 49 im Einzelnen darstellt. Der Deutlichkeit halber wurde die Federleiste 49 und die zugehörige Führungsnut 50 gegenüber der Darstellung in Figur 14 überhöht gezeichnet. Es ist jedoch grundsätzlich auch denkbar, den in Figur 14 dargestellten Gehäusegrundkörper 44 und die Federleisten 49 tatsächlich so zu modifizieren, dass sich die Federleisten 49 von der Leiterplatte 42 bis zu einer Deckenwand 53 des Gehäusegrundkörpers 44 erstrecken.

In Figur 15A ist die Leiterplatte 42 bereits in den Gehäusegrundkörper 44 eingeschoben. Die Federleiste 49 befindet sich noch im entspannten Zustand vor der vorderseitigen Öffnung 43 des Gehäusegrundkörpers 44.

Zu dem in Figur 15B dargestellten Zeitpunkt ist die Leiterplatte 42 bereits weiter in den Gehäusegrundkörper 44 eingeführt worden. In Figur 15B ist ein vorderes Ende 54 der Federleiste 49 mit einem nicht dargestellten Werkzeug aufgenommen worden und die Federleiste 49 auseinander gezogen worden. Das zum Spannen der Federleiste 49 verwendete Werkzeug ist durch die rückseitige Öffnung 51 hindurch in den Gehäusegrundkörper 44 eingeführt worden.

Es sei angemerkt, dass zum Aufziehen der Federleiste 49 nicht unbedingt ein durch die rückseitige Öffnung 51 hindurch eingeführtes Werkzeug erforderlich ist. Denkbar ist auch, das Ende 54 der Federleiste 49 vor dem Einschieben auf der Leiterplatte 42 zu befestigen. Nach dem Einführen der Leiterplatte 42 kann dann das Ende 54 der Federleiste 49 von der Leiterplatte 42 gelöst werden.

Nach dem vollständigen Einführen der Leiterplatte 42 wird die Federleiste 49, wie in Figur 15C dargestellt, losgelassen. Die Federleiste zieht sich daraufhin zusammen, bis sie sowohl an der Leiterplatte 42 als auch an der Deckenwand 53 des Gehäusegrundkörpers 44 anliegt. Die geringe Höhe des Gehäusegrundkörpers 44 oder der Führungsnut 50 erlaubt keine vollkommene Entspannung der Federleiste 49.

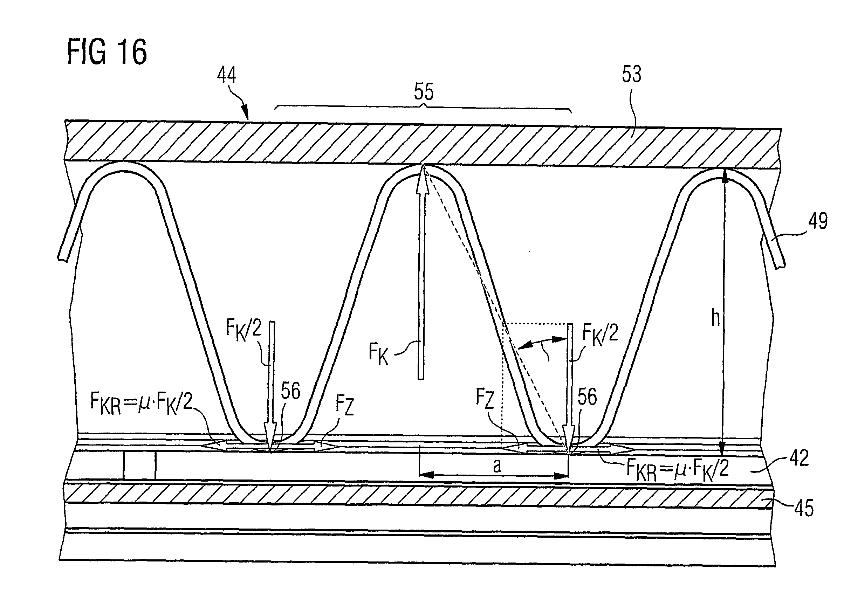

In Figur 16 sind die auf die Federleiste 49 wirkenden Kräfte schematisch dargestellt. Die auf die Federleiste 49 wirkenden Kräfte werden am Beispiel eines Federsegments 55 erläutert.

Axiale Entspannkräfte F_{z}, die an leiterplattenseitigen Scheitelpunkten 56 des Federsegments 55 angreifen, führen zu einem Zusammenziehen (a-Δa) und zu einem Höherwerden (h+Δh) des Federsegments 55. Dabei kommt es zu einer Kraftübersetzung der Entspannkraft F_{z} zu der Anpresskraft Fₖ, die vom Kegelwinkel α abhängt, der durch das Verhältnis von Höhe h zu Segmentlänge a bestimmt wird. Bei einem Kegelwinkel α < 45° wird die Anpresskraft Fₖ gegenüber der Entspannkraft F_{z} verstärkt.

Zu berücksichtigen ist noch, dass die Entspannkraft F_{z} um die Reibungskraft F_{kR} vermindert wird, wobei gilt: F_{kR} = µ Fₖ /2. Die Reibungskraft F_{kR} steigt mit größer werdender Anpresskraft Fₖ an. Bei einem Gleichgewicht zwischen der Reibungskraft F_{kR} und der Entspannkraft F_{z} wird keine weitere Anpresskraft auf die Leiterplatte 42 übertragen. Dies ist bei einem bestimmten Kegelwinkel α_{R} der Fall. Dieser Kegelwinkel kann wie folgt bestimmt werden: aus Fₖ/2 = F_{z} / tanα_{R} = µ Fₖ /2 tanα_{R} folgt µ = tanα_{R}. Die maximal erreichbare Anpresskraft Fₖ im Federsegment 55 ist daher durch den Reibungskoeffizienten für den Kontakt zwischen Federleiste 49 und Leiterplatte 42 begrenzt.

Es sei angemerkt, dass die zusätzliche Reibungskraft zwischen der Federleiste 49 und der Deckenwand 53 nicht explizit berücksichtigt worden ist. Implizit ist die Reibung zwischen der Federleiste 49 und der Deckenwand 53 jedoch im Betrag der Entspannkraft F_{z} berücksichtigt, da die Größe dieser Kraft auch von der Reibung zwischen der Federleiste 49 und der Deckenwand 53 abhängt.

Durch das Entspannen der schlangenförmigen Federleiste 49 in der Führungsnut 50 und das Aufstellen der Federschenkel der Federleiste 49 wird eine Anpresskraft F_{z} auf die Leiterplatte 42 erzeugt, welche die Leiterplatte 42 fest auf die Schultern 45 des Gehäusebodens 46 presst. Die Leiterplatte 42 wird dadurch im Gehäusegrundkörper 44 mechanisch fixiert, was zu einer guten Wärmeleitung zwischen der Leiterplatte 42 und dem Gehäusegrundkörper 44 führt.

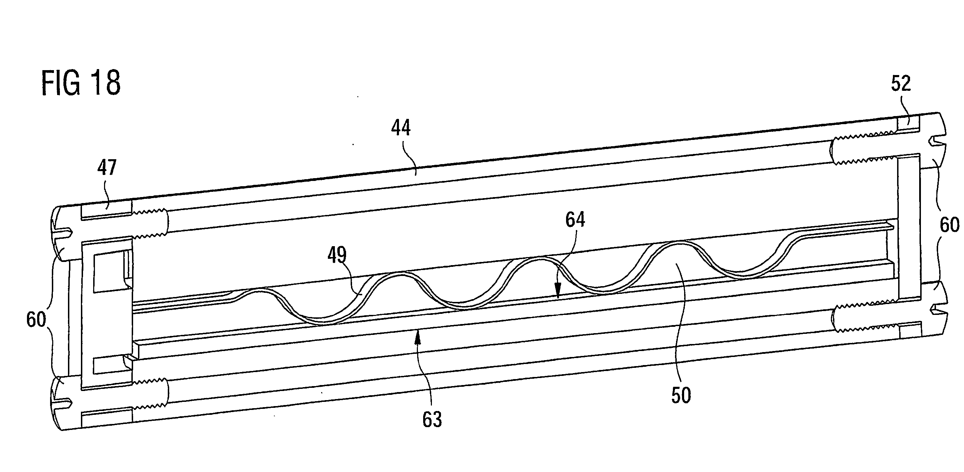

Grundsätzlich ist es möglich, anstelle der als Zugfeder ausgebildeten Federleiste 49 eine Druckfeder zu verwenden. Ein derartiges Ausführungsbeispiel ist in Figur 17 dargestellt. Bei dem in Figur 17 dargestellten Ausführungsbeispiel wird von außen eine Presskraft 57 aufgebracht. Durch die Presskraft 57 wird die Federleiste 49 komprimiert. Aufgrund ungleichmäßiger Reibungskoeffizienten an Klemmorten 58 kann eine bestimmte Federflanke 59 der schlangenförmigen Federleiste 49 steiler als andere Federflanken aufgestellt werden. In diesem Fall wird nahezu die gesamte Presskraft 57 an den Klemmorten 58 vor der Federflanke 59 absorbiert. Insbesondere wird die Presskraft 57 nicht auf die weiteren stromab liegenden Federsegmente übertragen. Denn je größer der absorbierte Anteil der Presskraft 57 in einem Federsegment 55 ist, desto steiler stellen sich die Federflanken 59 auf und desto größer ist die auf die Leiterplatte 42 und die Deckenwand 53 wirkende Anpresskraft, was wiederum den Anteil der Presskraft 57 erhöht, der im jeweiligen Federsegment 55 absorbiert wird. Dieser Effekt kann ein ungleichmäßiges Zusammenschieben der Federleiste 49 bewirken. Infolgedessen kommt es zu einer örtlich ungleichmäßigen Verteilung der auf die Leiterplatte 42 wirkenden Presskraft.

Falls die Federleiste 49 jedoch als Zugfeder ausgebildet ist, besteht diese Gefahr nicht. Wenn ein Klemmort 58 mit potentieller Reibkrafterhöhung vorhanden ist, werden sich die stromab liegenden Federsegmente weiterhin zusammenziehen wollen und die Federflanke 59 des aufgrund dieser erhöhten Reibung potentiell klemmenden Federsegments 55 wegziehen und damit die Steilheit der Federflanken 59 verringern. Dadurch wird die auf die Leiterplatte 42 und die Deckenwand 53 wirkende Anpresskraft verringert. Die Verringerung der Anpresskraft setzt dann die Reibkraft zwischen der Federleiste 49 und der Leiterplatte 42 und dem Gehäusegrundkörper 44 herab. Die in den Federsegmenten 55 abseits des verklemmten Federsegments 55 wirkenden Entspannkraft zieht daher das verklemmte Federsegment 55 an, wodurch die gesamte Federleiste 49 im Ergebnis gleichmäßig verkürzt wird. Dieser Ausgleichseffekt läuft an jedem Kontaktort zwischen der Federleiste 49 und der Leiterplatte 42 und dem Gehäusegrundkörper 44 ab und gewährleistet eine gleichmäßige Kraftverteilung der auf die Leiterplatte 42 wirkenden Anpresskraft.

Ein weiterer Vorteil einer als Zugfeder ausgebildeten Federleiste 49 besteht darin, dass nicht ständig die Presskraft 57 von außen aufgebracht werden muss, um die Leiterplatte 42 niederzuhalten. Die zum Niederhalten der Leiterplatte 42 erforderliche axiale Federkraft wird von einer als Zugfeder ausgebildeten Federleiste 49 selbst erzeugt und selbstständig aufrechterhalten, ohne dass von außen auf die Federleiste 49 eingewirkt werden muss. Letzteres bedeutet eine erhebliche Montageerleichterung, da die Abdeckung 52 bei einer als Zugfeder ausgebildeten Federleiste 49 einfach auf die rückseitige Öffnung 51 aufgeschraubt werden kann, ohne dass dabei die Federleiste 49 komprimiert werden muss.

In Figur 18 ist ein Querschnitt durch das Schaltungsmodul 41 im fertig montierten Zustand dargestellt, wobei es sich bei der Federleiste 49 um eine Zugfeder oder eine Druckfeder handeln kann. Unabhängig davon sind bei der dargestellten Ausführungsform die Abdeckungen 47 und 52 mit Schrauben 60 am Gehäusegrundkörper befestigt. Wenn es sich bei der Federleiste 49 um eine Druckfeder handelt, wird die zur Komprimierung der Druckfeder notwendige Presskraft von den Abdeckungen 47 und 52 aufgebracht.

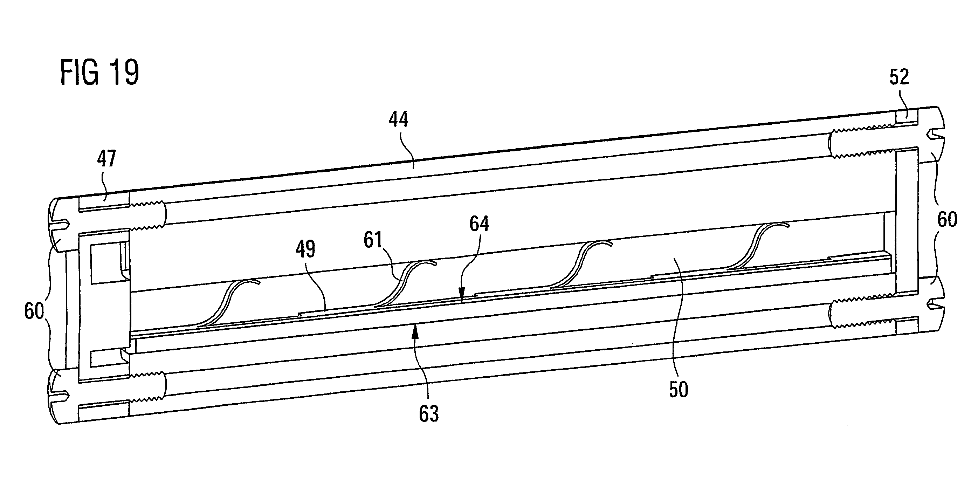

In Figur 19 ist eine weitere Ausführungsform des Schaltungsmoduls 41 dargestellt, bei dem die Federleiste 49 einzelne Federzungen 61 aufweist. Diese Ausführungsform ist insbesondere dann von Vorteil, wenn die Federleiste 49 zum Beispiel in der Leiterplatte 42 verrastet werden soll. Ferner ist es von Vorteil, wenn die den Federzungen 61 abgewandte Flachseite der Federleiste 49 auf der Leiterplatte 42 aufliegt, da diese dann gleichmäßig belastet wird. Außerdem können derartige Federleisten 49 besonders einfach gefertigt werden.

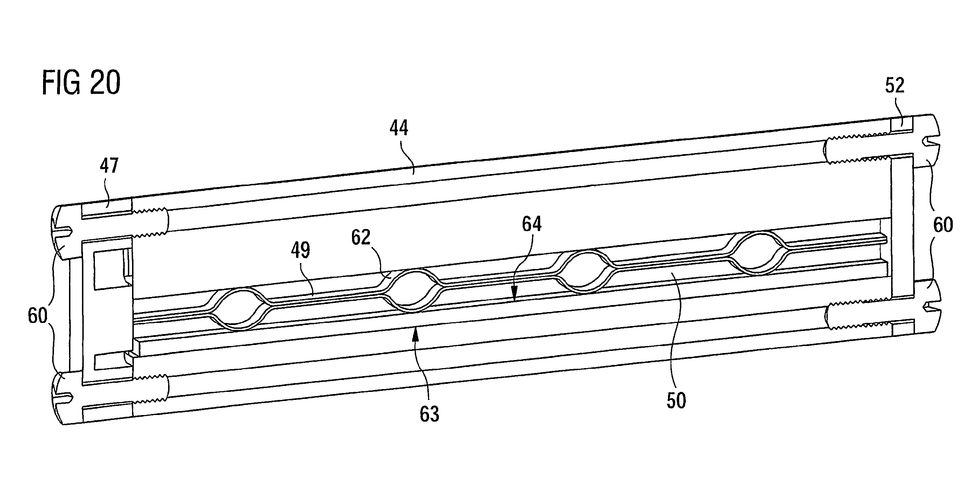

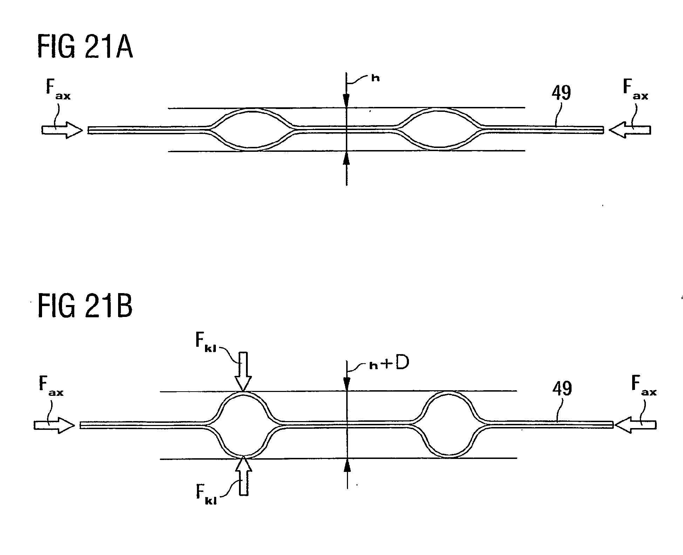

In Figur 20 ist schließlich ein weiteres Ausführungsbeispiel dargestellt, bei dem die Federleiste 49 Federringe 62 aufweist. Die in dem Ausführungsbeispiel der Figur 20 dargestellte Federleiste 49 kann man sich auch aus zwei schlangenförmig ausgebildeten Federleisten zusammengesetzt denken. Die Federleiste 49 des in Figur 20 dargestellten Ausführungsbeispiels kann ebenfalls wie die in den Figuren 14 bis 18 dargestellte Federleiste 49 als Zug- oder Druckfeder ausgebildet sein. In den Figuren 21A und 21B ist die Funktion der Federleiste 49 aus Figur 20 dargestellt. Durch Einwirken einer Presskraft Fₐₓ werden die Federringe 62 zu hochgestellten Ellipsen verformt, so dass die Federringe 62 eine Anpresskraft Fₖₗ auf die Leiterplatte 42 und den Gehäusegrundkörper 44 ausüben.

Der Vorteil dieser Ausführungsformen ist, dass sich die Federleisten 49 der in Figur 19 und 20 dargestellten Ausführungsbeispiele leichter überdrücken lassen, als die schlangenförmigen Federleisten 49 der in den Figuren 14 bis 18 dargestellten Ausführungsbeispiele. Bei den in den Figuren 19 und 20 dargestellten Ausführungsbeispielen ist daher weniger zu befürchten, dass die Federleiste 49 beim Einschieben verklemmt, wie es bei der schlangenförmigen Federleiste 49 der Fall ist.

Es sei angemerkt, dass weitere abgewandelte Ausführungsformen von Federleisten verwendet werden können. Zum Beispiel ist auch eine Federleiste mit einem einzigen Federsegment 55 zum Niederhalten der Leiterplatte 42 verwendbar.

Eine weitere denkbare Ausführungsform umfasst eine Federleiste, bei der mehrere übereinander angeordnete Federringe 62 für die zum Niederhalten der Leiterplatte 42 notwendige Anpresskraft sorgen. Eine derartige Federleiste kann man sich als einen Stapel von übereinander angeordneten schlangenförmigen Federleisten denken, die zusammen ein federndes Geflecht bilden.

Den in den Figuren 19 bis 21 dargestellten Ausführungsbeispielen ist gemeinsam, dass die Leiterplatte 42 so in den Gehäusegrundkörper 44 eingebracht ist, dass eine Flachseite 63 dem Gehäuseboden 46 und eine Flachseite 64 der Deckenwand 53 zugewandt sind. Dies bietet den Vorteil, dass die Federleiste 49 zusammen mit der Leiterplatte 42 in den Gehäusegrundkörper 44 eingebracht werden kann. Zu diesem Zweck kann die Federleiste 49 auch an einer der Abdeckungen 47 und 52 angebracht sein.

Bei den in den Figuren 14 bis 21 dargestellten Ausführungsbeispielen wird die Leiterplatte 42 im Wesentlichen durch die Federkraft der Federleiste 49 und durch die Abdeckungen 47 und 52 fixiert. Bei einer Leiterplatte, die flächenmäßig kleiner als ein zugeordneter Gehäusegrundkörper ist, können beispielsweise im Bereich der Führungsnuten Noppen oder Stifte vorgesehen sein, durch die die Leiterplatte in Einschieberichtung fixiert ist.

Außerdem ist es möglich, neben den an den Rändern der Leiterplatte angeordneten Federleisten eine oder mehrere Federleisten in einem mittleren Bereich der Leiterplatte vorzusehen. In diesem Fall ist es zweckmäßig, die Leiterplatte an den Orten, an den die Federleiste anliegt, abzustützen, um ein Brechen der Leiterplatte zu verhindern.

Bei einer weiteren abgewandelten Ausführungsform, sind an den Leiterplatten nach der Art eines Bauelements Querleisten angebracht, an denen sich in Längsrichtung erstreckende Federleisten angebracht sind. In diesem Fall brauchen die Federleisten nicht an den zum Verschluss des Gehäusegrundkörpers verwendeten Abdeckungen angebracht sein.

Schließlich ist es auch möglich, Längsleisten zwischen Leiterplatte und Gehäusegrundkörper einzuziehen an denen eine oder mehrere sich in Querrichtung erstreckende Federleisten angebracht sind.

Abschließend sei noch angemerkt, dass das Schaltungsmodul nicht notwendigerweise eine Leiterplatte aufnehmen muss. Es ist auch denkbar eine einzelnes Bauelement, zum Beispiel ein Relais oder einen Transformator, in dem Gehäusegrundkörper einzubringen. In diesem Fall kann auf die gekapselte Führungsnuten verzichtet werden, da nicht die Gefahr besteht, dass das Bauelement beim Einführen durch die Federleisten beschädigt wird.

## Patentansprüche

1. Verfahren zur Montage eines Schaltungsmoduls, bei dem ein Schaltungsträger (1, 42) mit seinen Flachseiten (63, 64) zu Wänden (20, 21, 46, 53) eines Gehäusegrundkörpers (10, 35, 44) weisend in den Gehäusegrundkörper (10, 35, 44) eingebracht wird und der Gehäusegrundkörper (10, 35, 44) mit Hilfe von Abdeckelementen (6, 25, 37, 47, 52) verschlossen wird, **dadurch gekennzeichnet, dass** zwischen Schaltungsträger (1, 42) und Gehäusegrundkörper (10, 35, 44) eine langgestreckte Druckleiste (26, 49) eingebracht wird, durch die eine auf eine Flachseite (64) des Schaltungsträgers (1, 42) wirkende Druckkraft aufgebracht wird, und dass die Druckleiste (26, 49) durch auf der Innenseite des Gehäusegrundkörpers (10, 44) ausgebildete Führungsmittel (17, 18, 19, 50) geführt wird.

2. Verfahren nach Anspruch 1,
**dadurch gekennzeichnet, dass**
die als Zugfeder ausgebildete Druckleiste (26, 49) beim Einbringen des Schaltungsträgers (1, 42) aufgezogen und zum Fixieren des Schaltungsträgers (1, 42) im Gehäusegrundkörper (10, 44) entspannt wird.

3. Verfahren nach Anspruch 1,
**dadurch gekennzeichnet, dass**
die als Druckfeder ausgebildete Druckleiste (26, 49) zum Fixieren des Schaltungsträgers (1, 42) mit einer die Druckfeder komprimierenden Presskraft (57) beaufschlagt wird.

4. Verfahren nach Anspruch 3,
**dadurch gekennzeichnet, dass**
die Presskraft (57) von den Abdeckelementen (47, 52) des Gehäusegrundkörpers (44) aufgebracht wird.

5. Verfahren nach einem der Ansprüche 1 bis 4,
**dadurch gekennzeichnet, dass**
die Druckleiste (26, 49) im Inneren des Gehäusegrundkörpers (10, 44) durch eine gekapselte Führungsnut (17, 50) geführt wird.

6. Verfahren nach einem der Ansprüche 1 bis 5,
**dadurch gekennzeichnet, dass**
der Schaltungsträger (1, 42) von Führungselementen (16, 18, 19, 36, 45) geführt in den Gehäusegrundkörper (10, 35, 44) eingebracht wird.

7. Verfahren nach Anspruch 6,
**dadurch gekennzeichnet, dass**
der Schaltungsträger (1, 42) vor dem Einbringen in den Gehäusegrundkörper (10, 35, 44) beidseitig bestückt wird.

8. Verfahren nach einem der Ansprüche 1 bis 7,
**dadurch gekennzeichnet, dass**
ein Abdeckelement (6, 47) vor dem Einbringen des Schaltungsträgers (1, 42) in den Gehäusegrundkörper (10, 35, 44) an dem Schaltungsträger (1, 42) befestigt wird.

9. Verfahren nach Anspruch 8,
**dadurch gekennzeichnet, dass**
ein am Abdeckelement (6, 47) ausgebildetes Kontaktmittel (5, 7, 48) vor dem Einbringen des Schaltungsträgers (1, 42) in den Gehäusegrundkörper (10, 35, 44) an den Schaltungsträger (1, 42) angeschlossen wird.

10. Verfahren nach einem der Ansprüche 1 bis 9,
**dadurch gekennzeichnet, dass**
die Druckleiste (26, 49) zusammen mit dem Schaltungsträger (1, 42) in den Gehäusegrundkörper (10, 35, 44) eingebracht wird.

11. Verfahren nach einem der Ansprüche 1 bis 10,
**dadurch gekennzeichnet, dass**
ein mit der Druckleiste (26, 49) versehenes Abdeckelement (25, 47) auf eine Öffnung (15, 43) des Gehäusegrundkörpers (10, 35, 44) aufgebracht wird.

12. Verfahren nach einem der Ansprüche 1 bis 11,
**dadurch gekennzeichnet, dass**
die Druckleiste (26) vor dem Einführen in den Gehäusegrundkörper (10) an Sollbruchstellen (34) an die Länge des Gehäusegrundkörpers (10) angepasst wird.

13. Verfahren nach einem der Ansprüche 1 bis 12,
**dadurch gekennzeichnet, dass**
die Druckleiste (26) in einer Ausnehmung (33) eines gegenüberliegenden Abdeckelements (6) formschlüssig gehalten wird.

14. Verfahren nach einem der Ansprüche 1 bis 13,
**dadurch gekennzeichnet, dass**
an der Druckleiste (26) ein Sägezahnprofil (32) ausgebildet ist, das in Verrastungen der Ausnehmung (33) formschlüssig gehalten ist.

15. Verfahren nach Anspruch 13 oder 14,
**dadurch gekennzeichnet, dass**
der Gehäusegrundkörper (10, 35) zwischen gegenüberliegenden Abdeckelementen (6, 25, 37) eingeklemmt wird.

16. Verfahren nach einem der Ansprüche 1 bis 15,
**dadurch gekennzeichnet, dass**
ein Abdeckelement (37) mit Hilfe von Klemmmitteln (39, 40) beim Anbringen eines Abdeckelements (37) auf einer Öffnung (15) des Gehäusegrundkörpers (35) auf den Schaltungsträger (1) aufgesteckt wird.

17. Verfahren nach einem der Ansprüche 1 bis 16,
**dadurch gekennzeichnet, dass**
die Öffnungen (12, 15) auf den Querseiten (11, 14) des Gehäusegrundkörpers (10, 35) mit Hilfe von gleichen Dichtungen (24, 30) abgedichtet werden.

18. Schaltungsmodul mit einer im Inneren eines Gehäuses angeordneten elektronischen Komponente,
**dadurch gekennzeichnet, dass**
das Schaltungsmodul mit einem Verfahren nach wenigstens einem der Ansprüche 1 bis 17 herstellbar ist.

## Claims

1. Method for mounting a switching module, in which a circuit support (1, 42) is inserted into the basic housing element (10, 35, 44) with its flat sides (63, 64) facing walls (20, 21, 46, 53) of a basic housing element (10, 35, 44) and the basic housing element (10, 35, 44) is closed with the aid of cover elements (6, 25, 37, 47, 52),
**characterised in that**
a longitudinally extended pressure strip (26, 49) is inserted between the circuit support (1, 42) and the basic housing element (10, 35, 44), by means of which a compression force acting on a flat side (64) of the circuit support (1, 42) is applied and that the pressure strip (26, 49) is guided by guide means (17, 18, 19, 50) configured on the inside of the basic housing element (10, 44).

2. Method according to claim 1,
**characterised in that** the pressure strip (26, 49) configured as a tension spring is charged during insertion of the circuit support (1, 42) and released to fix the circuit support (1, 42) in the basic housing element (10, 44).

3. Method according to claim 1,
**characterised in that** the pressure strip (26, 49) configured as a compression spring for fixing the circuit support (1, 42) is subject to a pressure (57) that compresses the compression spring.

4. Method according to claim 3,
**characterised in that** the pressure (57) is applied by the cover elements (47, 52) of the basic housing element (44).

5. Method according to one of claims 1 to 4,
**characterised in that** the pressure strip (26, 49) is guided inside the basic housing element (10, 44) by an encapsulated guide groove (17, 50).

6. Method according to one of claims 1 to 5,
**characterised in that** the circuit support (1, 42) is guided by guide elements (16, 18, 19, 36, 45) during insertion into the basic housing element (10, 35, 44).

7. Method according to claim 6,
**characterised in that** the circuit support (1, 42) is fitted with components on both sides before insertion into the basic housing element (10, 35, 44).

8. Method according to one of claims 1 to 7,
**characterised in that** a cover element (6, 47) is fixed to the circuit support (1, 42) before insertion of the circuit support (1, 42) into the basic housing element (10, 35, 44).

9. Method according to claim 8,
**characterised in that** contact means (5, 7, 48) configured on the cover element (6, 47) are connected to the circuit support (1, 42) before insertion of the circuit support (1, 42) into the basic housing element (10, 35, 44).

10. Method according to one of claims 1 to 9,
**characterised in that** the pressure strip (26, 49) is inserted into the basic housing element (10, 35, 44) together with the circuit support (1, 42)).

11. Method according to one of claims 1 to 10,
**characterised in that** a cover element (25, 47) provided with the pressure strip (26, 49) is attached to an opening (15, 43) in the basic housing element (10, 35, 44).

12. Method according to one of claims 1 to 11,
**characterised in that** the pressure strip (26) is tailored to the length of the basic housing element (10) at breaking points (34) before insertion into the basic housing element (10).

13. Method according to one of claims 1 to 12,
**characterised in that** the pressure strip (26) is held positively in a recess (33) in an opposite cover element (6).

14. Method according to one of claims 1 to 13,
**characterised in that** a saw-tooth profile (32) is configured on the pressure strip (26) and is held positively in latch points on the recess (33).

15. Method according to claim 13 or 14,
**characterised in that** the basic housing element (10, 35) is clamped between opposite cover elements (6, 25, 37).

16. Method according to one of claims 1 to 15,
**characterised in that** a cover element (37) is fixed to the circuit support (1) by way of clamping means (39, 40) during attachment of a cover element (37) to an opening (15) in the basic housing element (35).

17. Method according to one of claims 1 to 16,
**characterised in that** the openings (12, 15) on the transverse sides (11, 14) of the basic housing element (10, 35) are sealed by means of identical seals (24, 30).

18. Switching module with an electronic component arranged inside a housing,
**characterised in that** the switching module can be produced using a method according to at least one of claims 1 to 17.

## Revendications

1. Procédé pour le montage d'un module de circuit dans lequel un support de circuit (1, 42) est inséré dans un corps de base de boîtier (10, 35, 44) avec ses côtés plats (63, 64) dirigés vers les parois (20, 21, 46, 53) du corps de base de boîtier (10, 35, 44) et le corps de base de boîtier (10, 35, 44) est fermé à l'aide d'éléments de fermeture (6, 25, 37, 47, 52),
**caractérisé en ce qu'**
entre le support de circuit (1, 42) et le corps de base de boîtier (10, 35, 44), est insérée une bande de compression allongée (26, 49) qui applique une force de compression agissant sur un côté plat (64) du support de circuit (1, 42) et **en ce que** la bande de compression (26, 49) est guidée par des moyens de guidage (17, 18, 19, 50) formés sur le côté intérieur du corps de base de boîtier (10, 44).

2. Procédé selon la revendication 1,
**caractérisé en ce que**
la bande de compression (26, 49) réalisée sous la forme d'un ressort de traction allongé s'étire lors de l'insertion du support de circuit (1, 42) et se détend pour immobiliser le support de circuit (1, 42) dans le corps de base de boîtier (10, 44).

3. Procédé selon la revendication 1,
**caractérisé en ce que**
pour l'immobilisation du support de circuit (1, 42), la bande de compression (26, 49) réalisée sous la forme d'un ressort de compression est sollicitée avec une force de pression (57) qui comprime le ressort de compression.

4. Procédé selon la revendication 3,
**caractérisé en ce que**
la force de pression (57) est appliquée par les éléments de fermeture (47, 52) du corps de base de boîtier (44).

5. Procédé selon une des revendications 1 à 4,
**caractérisé en ce que**
la bande de compression (26, 49) est guidée à l'intérieur du corps de base de boîtier (10, 44) par une rainure de guidage fermée (17, 50).

6. Procédé selon une des revendications 1 à 5,
**caractérisé en ce que**
le support de circuit (1, 42) est inséré dans le corps de base de boîtier (10, 35, 44) en étant guidé par des éléments de guidage (16, 18, 19, 36, 45).

7. Procédé selon la revendication 6,
**caractérisé en ce que**
le support de circuit (1, 42) est équipé sur les deux faces avant d'être inséré dans le corps de base de boîtier (10, 35, 44).

8. Procédé selon une des revendications 1 à 7,
**caractérisé en ce qu'**
un élément de fermeture (6, 47) est fixé au support de circuit (1, 42) avant l'insertion du support de circuit (1, 42) dans le corps de base de boîtier (10, 35, 44).

9. Procédé selon la revendication 8,
**caractérisé en ce qu'**
un moyen de contact (5, 7, 48) formé sur l'élément de fermeture (6, 47) est connecté au support de circuit (1, 42) avant l'insertion du support de circuit (1, 42) dans le corps de base de boîtier (10, 35, 44).

10. Procédé selon une des revendications 1 à 9,
**caractérisé en ce que**
la bande de compression (26, 49) est insérée dans le corps de base de boîtier (10, 35, 44) conjointement avec le support de circuit (1, 42).

11. Procédé selon une des revendications 1 à 10,
**caractérisé en ce qu'**
un élément de fermeture (25, 47) muni de la bande de compression (25, 49) est monté sur une ouverture (15, 43) du corps de base de boîtier (10, 35, 44).

12. Procédé selon une des revendications 1 à 11,
**caractérisé en ce que**
la bande de compression (26) est adaptée à la longueur du corps de base de boîtier (10) au niveau de zones d'amorce de rupture (34) avant l'introduction dans le corps de base de boîtier (10).

13. Procédé selon une des revendications 1 à 12,
**caractérisé en ce que**
la bande de compression (26) est maintenue par complémentarité de forme dans un évidement (33) d'un élément de fermeture opposé (6).

14. Procédé selon une des revendications 1 à 13,
**caractérisé en ce que**,
sur la bande de compression (26), est formé un profil en dents de scie (32) qui est tenu par complémentarité de forme dans des encliquetages de l'évidement (33).

15. Procédé selon la revendication 13 à 14,
**caractérisé en ce que**
le corps de base de boîtier (10, 35) est serré entre des éléments de fermeture opposés (6, 25, 37).

16. Procédé selon une des revendications 1 à 15,
**caractérisé en ce qu'**
un élément de fermeture (37) est emboîté sur le support de circuit (1) à l'aide de moyens de serrage (39, 40) au moment de la mise en place d'un élément de fermeture (37) sur l'ouverture (15) du corps de base de boîtier (35).

17. Procédé selon une des revendications 1 à 16,
**caractérisé en ce que**
les ouvertures (12, 15) situées sur les côtés transversaux (11, 14) du corps de base de boîtier (10, 35) sont fermées à joint étanche à l'aide de garnitures d'étanchéité (24, 30) identiques.

18. Module de circuit possédant des composants électroniques disposés à l'intérieur d'un boîtier,
**caractérisé en ce que** le module de circuit peut être fabriqué par un procédé selon au moins une des revendications 1 à 17.
